# EUROPÄISCHE PATENTSCHRIFT

(11) **EP 0 788 656 B1**
(45) Veröffentlichungstag und Bekanntmachung des Hinweises auf die Patenterteilung: **16.08.2000**
(21) Anmeldenummer: 94931493.4
(22) Anmeldetag: 28.10.1994
(51) Int. Cl.: H01L 27/02

(54) **FESTKÖRPERSCHALTELEMENT MIT ZWEI SOURCE-ELEKTRODEN UND FESTKÖRPERSCHALTER MIT EINEM SOLCHEN ELEMENT**
SOLID-STATE SWITCHING ELEMENT WITH TWO SOURCE ELECTRODES AND SOLID-STATE SWITCH WITH SUCH AN ELEMENT
ELEMENT INTERRUPTEUR MONOLITHIQUE AVEC DEUX ELECTRODES DE SOURCE ET INTRRUPTEUR MONOLITHIQUE EQUIPE D'UN TEL ELEMENT

(43) Veröffentlichungstag der Anmeldung: 13.08.1997
(73) Patentinhaber: SIEMENS AKTIENGESELLSCHAFT, 80333 München (DE)
(72) Erfinder: MAIER, Reinhard, D-91074 Herzogenaurach (DE); ZIERHUT, Hermann, D-93073 Neutraubling (DE); MITLEHNER, Heinz, D-91080 Uttenreuth (DE)
(86) Internationale Anmeldenummer: DE9401271
(87) Internationale Veröffentlichungsnummer: WO9613859

(56) Entgegenhaltungen:
- EP-A- 0 523 800
- EP-A- 0 565 179
- FR-A- 2 450 504
- GB-A- 2 263 017
- US-A- 5 023 692
- US-A- 5 237 194

## Beschreibung

Die Erfindung bezieht sich zunächst auf ein Festkörperschaltelement, das mit paarweise antiseriellen Halbleiterbereichen arbeitet, wobei jeder Halbleiterbereich Kennlinien hat, wie sie FETs aufweisen, also technologiegebunden auch innere Bodydioden im Inversbetrieb.

Bei Schaltmaßnahmen in elektrischen Stromkreisen soll in Abhängigkeit von der Größe des durch einen Stromkreis fließenden Stromes dieser bei Überschreiten eines vorgegebenen Maximalwertes abgeschaltet werden, ohne daß dabei größere Überströme entstehen. Bei elektronischen Schaltern wird das Problem üblicherweise dadurch gelöst, daß der Spannungsfall an einem Widerstand als Auslösekriterium gemessen wird und eine Steuerlogik ein Schutz zum Unterbrechen des Stromkreises auslöst. Anstelle eines Widerstands werden auch Stromwandler eingesetzt. Bei elektromagnetischen Schutzschaltern arbeitet ein Anker einer stromdurchflossenen Spule auf ein Schaltschloß zum Öffnen von Kontakten in den abzuschaltenden Leitern. Bei allen derartigen Anordnungen kann infolge der Schaltverzögerung nachdem ein Kurzschluß aufgetreten ist, der Strom bis zum Abschalten noch hohe Werte annehmen.

Es ist eine stromlimitierende Schaltung mit einem MOSFET bekannt (US-A-5 023 692), das mit einer Drain-Elektrode und zwei verschiedenen Source-Elektroden arbeitet. Hiermit können Gleichspannungen geschaltet werden, wozu ein zusätzlicher Transistor benötigt wird. Es sind auch Bereiche mit Elektronensammler, Gate, und Elektronenspender verschiedener Anzahl eingesetzt.

Der Erfindung liegt die Aufgabe zugrunde, ein Festkörperschaltelement zu entwickeln, das ein vergleichsweise verzögerungsfreies Schalten ermöglicht.

Die Lösung der geschilderten Aufgabe erfolgt nach der Erfindung durch ein Festkörperschaltelement nach Anspruch 1. Die Halbleiterbereiche im Zelldesign weisen jeweils außer Elektronensammler, Drain, einer den Elektronenfluß steuernden Elektrode, Gate, jeweils zwei Elektronenspender, Source, auf. Die Kennlinienscharen sind im ersten und dritten Quadranten gebildet, die sich mit Bodydioden im Inversbetrieb überlagern. Die Elektroden mehrerer Zellen sind zusammengeführt. Die an der ersten Source, die als Laststromelektrode bzw. Lastsource zur Verfügung steht, angeschlossene wirksame Halbleiterfläche ist größer als die an der zweiten Source, die als Steuerelektrode bzw. als Steuersource zur Verfügung steht. Entsprechend dem Flächenverhältnis des Layouts kann über die Steuersource ein im Verhältnis zur Lastsource entsprechend heruntergeteilter Strom geführt werden, der mit elektronischen Mitteln leichter bereitzustellen oder zu verarbeiten ist.

Die Halbleiterfläche der Lastsource zu der der Steuersource kann vorteilhaft in einem Verhältnis von 10² bis 10⁴ zu eins stehen. Vorteilhafterweise werden die Halbleiterbereiche aus einem Material gefertigt, das einer Betriebstemperatur von 300° bis 600° C standhält. Geeignet ist beispielsweise Siliciumcarbid, SiC.

Das Festkörperschaltelement kann so aufgebaut sein, daß die Steuersource zentral in einem umgebenden Feld der Lastsource angeordnet ist. Die Lastsource kann auch ringförmig um die Steuersource angeordnet sein.

Das Festkörperschaltelement kann weitere Elemente, insbesondere einen ohmschen Widerstand, in Chiptechnologie integriert aufnehmen. Vorzugsweise ist ein Widerstand als weiteres Element zwischen Lastsource und Steuersource elektrisch eingeschaltet.

Aus derartigen Festkörperschaltelementen können leicht Festkörperschalter aufgebaut werden. Nach einer Weiterbildung sind bei einem Festkörperschalter mit einem Element der geschilderten Art bei zwei Halbleiterbereichen die Steuersource mit dem negativen Eingang eines Operationsverstärkers verbunden und die Lastsource mit dem positiven Eingang. Potentialmäßig zwischen den beiden Anschlüssen ist ein ohmscher Widerstand eingeschaltet, wobei die Gate-Elektroden der beiden Halbleiterbereiche mit dem Ausgang des Operationsverstärkers verbunden sind. Die Drain-Elektroden der beiden Halbleiterbereiche stehen als Lastanschlüsse zur Verfügung. Ein derartiger Festkörperschalter kann vorteilhaft in einem Chip integriert sein oder auch mit diskreten Bauelementen zusammenarbeiten. Für größere Schaltleistungen können die Halbleiterbereiche mit ihrem sogenannten Waver auf einem Kühlkörper aufgebracht sein.

Die Erfindung soll nun anhand von in der Zeichnung grob schematisch wiedergegebenen Ausführungsbeispielen näher erläutert werden:
In FIG 1 ist ein Festkörperschaltelement in Verbindung mit einer Steuereinheit und einem elektromagnetischen Schalter veranschaulicht.
In FIG 2 ist ein Kennlinienfeld des Festkörperschaltelements nach FIG 1 dargestellt.
In FIG 3 ist der designmäßige Aufbau eines Festkörperschaltelements im Sinne eines Layouts wiedergegeben.
In FIG 4 ist ein weiteres Layout dargestellt.
In FIG 5 ist für einen Festkörperschalter mit einem geschilderten Festkörperschaltelement der elektrische Schaltungsaufbau nach einer Weiterbildung wiedergegeben.

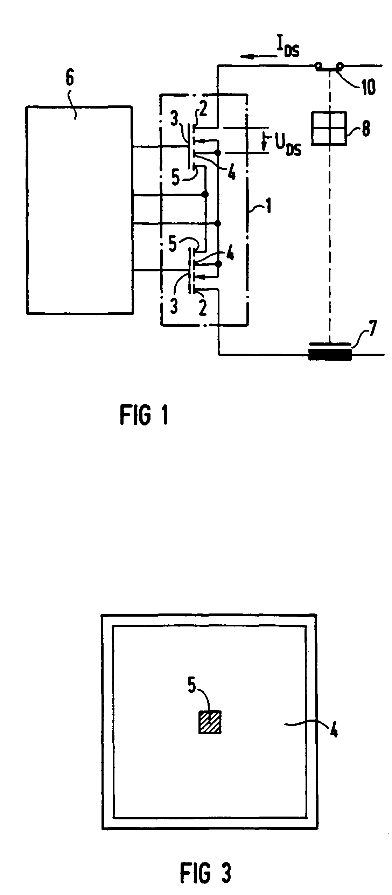

Das Festkörperschaltelement 1 nach FIG 1 weist zwei Halbleiterbereiche in antiserieller Anordnung auf, die jeweils Kennlinien haben, wie sie FETs aufweisen. Jeder Halbleiterbereich weist einen Elektronensammler, Drain 2, auf, eine den Elektronenfluß steuernde Elektrode, Gate 3, und jeweils zwei Elektronenspender, Source 4 und Source 5, auf, wobei die erste Source als Laststromelektrode bzw. Lastsource 4 zur Verfügung steht und die zweite Source als Steuerelektrode bzw. als Steuersource 5 zur Verfügung steht. Mit einer Steuereinheit 6 soll hier zunächst veranschaulicht werden, daß das Festkörperschaltelement 1 angesteuert werden kann. Es kann in Verbindung mit einem elektromagnetischen Schutzschalter eingesetzt werden. Der elektromagnetische Schutzschalter ist mit einem elektromagnetischen Auslöser 7 und einem Schaltschloß 8 veranschaulicht, das auf Schaltkontakte 10 einwirkt.

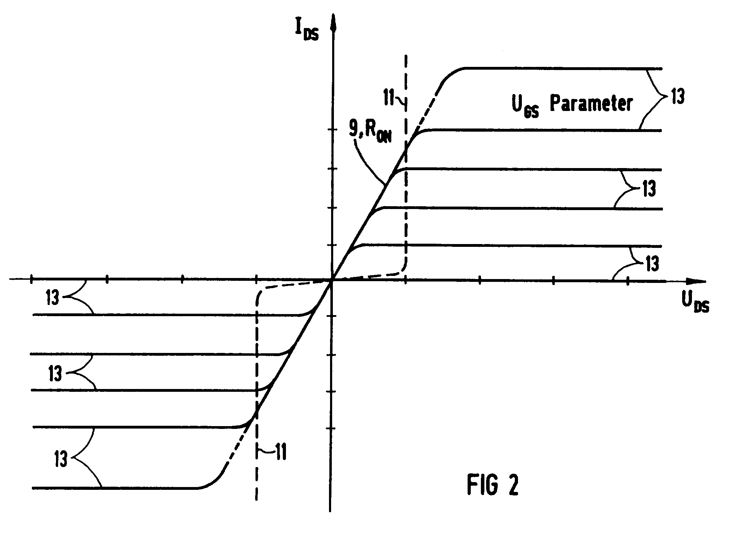

In FIG 2 ist ein Kennlinienfeld wiedergegeben, das mit der Kennlinienschar 13 im ersten Quadranten das Verhalten eines Halbleiterbereiches für einen Drain-Source-Strom I_{DS} und eine Drain-Source-Spannung U_{DS} in Abhängigkeit von der Gate-Source-Spannung U_{GS} als Parameter veranschaulicht. Der Ausschaltzustand wird durch die Abszisse wiedergegeben. Mit steigender Gate-Source-Spannung U_{GS} lehnen sich die Kennlinien 13 beginnend im Ursprung immer stärker an eine Gerade 9, R_{ON}, an. In anderer Betrachtungsweise wird bei hoher Gate-Source-Spannung eine steile Kennlinie 9 erreicht, die allgemein als ON-Widerstand verstanden wird, da sie ein lineares Verhalten zwischen Strom und Spannung aufzeigt. Eine steile Gerade 9 entspricht einem niedrigen ON-Widerstand. Bei antiserieller Schaltung von zwei Halbleiterbereichen verlaufen die Kennlinien 13 und RON im ersten und dritten Quadranten. Die Bodydiode im Inversbetrieb ergibt eine Überlagerung des Kennlinienfeldes mit einer Kennlinie 11 im dritten Quadranten zum Kennlinienfeld 13 im ersten Quadranten und eine Kennlinie 11 im ersten Quadranten zum Kennlinienfeld 13 im dritten Quadranten.

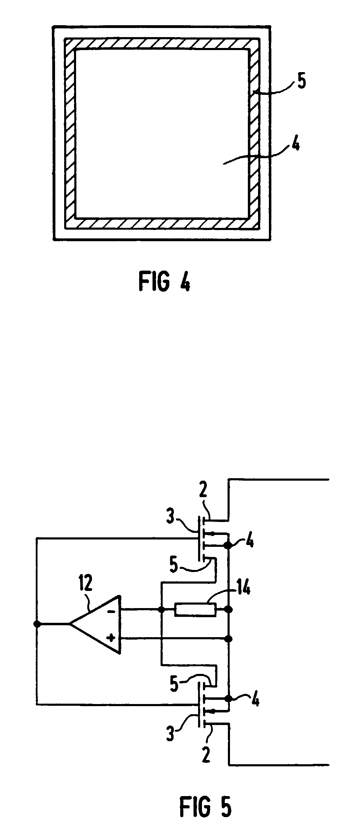

In FIG 3 ist ein Ausführungsbeispiel für das Layout eines Festkörperschaltelements wiedergegeben, wobei die Steuersource 5 zentral in einem umgebenden Feld der Lastsource 4 angeordnet ist. In FIG 4 ist ein weiteres Ausführungsbeispiel dargestellt, wobei die Steuersource 5 ringförmig um die Lastsource 4 angeordnet ist.

Der Festkörperschalter nach FIG 5 arbeitet mit zwei Halbleiterbereichen der bereits geschilderten Art in antiserieller Anordnung. Die Steuersource 5 ist mit dem negativen Eingang eines Operationsverstärkers 12 verbunden und die Lastsource 4 mit dem positiven Eingang, wobei potentialmäßig zwischen den beiden Anschlüssen ein ohmscher Widerstand 14 eingeschaltet ist. Die Gate-Elektroden 3 der beiden Halbleiterbereiche sind mit dem Ausgang des Operationsverstärkers 12 verbunden, wobei die Drain-Elektroden 2 der beiden Halbleiterbereiche als Lastanschlüsse zur Verfügung stehen. An Widerstand 14 entsteht durch den heruntergeteilten Laststrom im Verhältnis der wirksamen Halbleiterflächen der Lastsource zur Steuersource ein Spannungsfall, der mittels des Operationsverstärkers 12, bzw. eines Komparators, die für die Strombegrenzung der Halbleiterbereiche mit den Kennlinien eines FETs erforderliche Gatespannung aufbereitet, so daß diese in den stromsperrenden Zustand gesteuert werden. Insbesondere können die Halbleiterbereiche als MOSFETs ausgeführt sein und vorteilhaft aus SiC gefertigt sein.

## Patentansprüche

1. Festkörperschaltelement (1), das mit paarweise antiseriellen Halbleiterbereichen arbeitet, wobei jeder Halbleiterbereich Kennlinien hat, wie sie FETs aufweisen, also technologiegebunden auch innere Bodydioden im Inversbetrieb, wobei die Halbleiterbereiche im Zelldesign, jeweils außer Elektronensammler, Drain (2), einer den Elektronenfluß steuernden Elektrode, Gate (3), auch zwei Elektronenspender, Source (4, 5), aufweisen, wobei Kennlinienscharen im ersten und dritten Quadranten gebildet sind, die sich mit den Bodydioden im Inversbetrieb überlagern, wobei die Elektroden mehrerer Zellen zusammengeführt sind, wobei die an der ersten Source, die als Laststromelektrode bzw. Lastsource (4) zur Verfügung steht, angeschlossene wirksame Halbleiterfläche größer ist als die wirksame Halbleiterfläche an der zweiten Source, die als Steuerelektrode bzw. als Steuersource (5) zur Verfügung steht.

2. Festkörperschaltelement nach Anspruch 1,
**dadurch gekennzeichnet**,
daß die Halbleiterflächen der Lastsource (4) zu denen der Steuersource (5) im Verhältnis von 10² bis 10⁴ zu eins steht und daß die Halbleiterbereiche aus einem Material bestehen, das einer Betriebstemperatur von 300° bis 600° C standhält.

3. Festkörperschaltelement nach Anspruch 1 oder 2,
**dadurch gekennzeichnet**,
daß die Halbleiterbereiche jeweils aus Siliciumcarbid, SiC, bestehen.

4. Festkörperschaltelement nach einem der vorhergehenden Ansprüche,
**dadurch gekennzeichnet**,
daß die Steuersource (5) zentral in der Lastsource (4) angeordnet ist.

5. Festkörperschaltelement nach einem der Ansprüche 1 bis 3,
**dadurch gekennzeichnet**,
daß die Steuersource (5) ringförmig um die Lastsource (4) angeordnet ist.

6. Festkörperschaltelement nach einem der vorhergehenden Ansprüche,
**dadurch gekennzeichnet**,
daß zwischen Lastsource (4) und Steuersource (5) ein ohmscher Widerstand (14) eingefügt bzw. integriert ist.

7. Festkörperschaltelement nach einem der vorhergehenden Ansprüche,
**dadurch gekennzeichnet**,
daß die Halbleiterbereiche aus Siliciumcarbid, SiC, gebildet sind.

8. Festkörperschalter mit einem Festkörperschaltelement mit zwei Halbleiterbereichen nach einem der vorhergehenden Ansprüche,
**dadurch gekennzeichnet**,
daß die Steuersource (5) mit dem negativen Eingang eines Operationsverstärkers (12) verbunden sind und die Lastsource (4) mit dem positiven Eingang, wobei potentialmäßig zwischen den beiden Anschlüssen ein ohmscher Widerstand (14) eingeschaltet ist, wobei die Gate-Elektroden (3) der beiden Halbleiterbereiche mit dem Ausgang des Operationsverstärkers (12) verbunden sind, wobei die Drain-Elektroden (2) der beiden Halbleiterbereiche als Lastanschlüsse zur Verfügung stehen.

9. Festkörperschalter nach Anspruch 8,
**dadurch gekennzeichnet**,
daß die Halbleiterbereiche mit ihrem sogenannten Waver auf einem Kühlkörper aufgebracht sind.

## Claims

1. Solid-state switching element (1), which operates with semiconductor regions which are anti-serial in pairs, wherein each semiconductor region has characteristic curves corresponding to characteristic curves of FETs, that is to say technology-dependent also inner body diodes in inverse operation, wherein the semiconductor regions in the cell design, in each case apart from electron collectors, drain (2), an electrode controlling the electron flux, gate (3), also have two electron donors, source (4, 5), wherein families of characteristics are formed in the first and third quadrant, which superimpose themselves with the body diodes in the inverse operation, wherein the electrodes of several cells are combined, wherein the effective semiconductor surface connected to the first source, which is available as load current electrode or load source (4), is larger than the effective semiconductor surface at the second source, which is available as control electrode and as control source (5).

2. Solid-state switching element according to claim 1, characterized in that the semiconductor surfaces of the load source (4) are to those of the control source (5) in a ratio of 10²:1 to 10⁴:1 and in that the semiconductor regions consist of a material which withstands an operating temperature of 300° to 600°C.

3. Solid-state switching element according to claim 1 or 2, characterized in that the semiconductor regions each consist of silicon carbide, SiC.

4. Solid-state switching element according to one of the preceding claims, characterized in that the control source (5) is arranged centrally in the load source (4).

5. Solid-state switching element according to one of claims 1 to 3, characterized in that the control source (5) is arranged in an annular manner about the load source (4).

6. Solid-state switching element according to one of the preceding claims, characterized in that an ohmic resistor (14) is inserted and integrated between the load source (4) and the control source (5).

7. Solid-state switching element according to one of the preceding claims, characterized in that the semiconductor regions are formed from silicon carbide, SiC.

8. Solid-state switch with a solid-state switching element with two semiconductor regions according to one of the preceding claims, characterized in that the control source (5) is connected to the negative input of an operational amplifier (12) and the load source (4) to the positive input, wherein in terms of potential an ohmic resistor (14) is inserted between the two terminals, wherein the gate electrodes (3) of the two semiconductor regions are connected to the output of the operational amplifier (12), wherein the drain electrodes (2) of the two semiconductor regions are available as load terminals.

9. Solid-state switch according to claim 8, characterized in that the semiconductor regions with their so-called waver are applied to a cooling body.

## Revendications

1. Elément (1) de coupure monolithique qui travaille avec des zones semi-conductrices anti-série par paires, chaque zone semi-conductrice ayant des courbes caractéristiques telles qu'en ont des FET, donc, ce qui est lié à la technologie, aussi des diodes substrats intérieures à fonctionnement en inverse, les zones semi-conductrices dans la structure à cellule comportant respectivement, outre un collecteur d'électrons, drain (2), une électrode commandant le flux d'électrons, grille (3), aussi deux dispensateurs d'électrons, sources (4, 5), les familles de courbes caractéristiques étant formées dans le premier et le troisième quadrants et se superposant aux diodes substrats en fonctionnement en inverse, les électrodes étant réunies en plusieurs cellules, la surface semi-conductrice active raccordée à la première source qui est à disposition comme électrode de courant de charge ou source (4) de charge étant plus grande que la surface semi-conductrice active sur la deuxième source qui est à disposition comme électrode de commande ou source (5) de commande.

2. Elément de coupure monolithique suivant la revendication 1, caractérisé en ce que les surfaces semi-conductrices de la source (4) de charge sont par rapport à la source (5) de commande dans le rapport de 10² à 10⁴ à un et en ce que les zones semi-conductrices sont en un matériau qui supporte une température de fonctionnement de 300°C à 600°C.

3. Elément de coupure monolithique suivant la revendication 1 ou 2, caractérisé en ce que les zones semi-conductrices sont chacune en carbure de silicium, SiC.

4. Elément de coupure monolithique suivant l'une des revendications précédentes, caractérisé en ce que la source (5) de commande est disposée de manière centrale dans la source (4) de charge.

5. Elément de coupure monolithique suivant l'une des revendications 1 à 3, caractérisé en ce que la source (5) de commande est disposée annulairement autour de la source (4) de charge.

6. Elément de coupure monolithique suivant l'une des revendications précédentes, caractérisé en ce qu'il est inséré ou intégré entre la source (4) de charge et la source (5) de commande une résistance (14) ohmique.

7. Elément de coupure monolithique suivant l'une des revendications précédentes, caractérisé en ce que les zones semi-conductrices sont en carbure de silicium, SiC.

8. Interrupteur monolithique comportant un élément de coupure monolithique ayant deux zones semi-conductrices suivant l'une des revendications précédentes, caractérisé en ce que la source (5) de commande est reliée à l'entrée négative d'un amplificateur (12) opérationnel et en ce que la source (4) de charge est reliée à l'entrée positive, une résistance (14) ohmique étant branchée en potentiel entre les deux bornes, les électrodes (3) de grille des deux zones semi-conductrices étant reliées à la sortie de l'amplificateur (12) opérationnel, les électrodes (2) de drain des deux zones semi-conductrices étant à disposition comme bornes de charge.

9. Interrupteur monolithique suivant la revendication 8, caractérisé en ce que les zones semi-conductrices sont déposées avec ce que l'on appelle leur waver sur un radiateur.
